# EUROPÄISCHE PATENTSCHRIFT

(11) **EP 3 076 411 B1**
(45) Veröffentlichungstag und Bekanntmachung des Hinweises auf die Patenterteilung: **29.11.2017**
(21) Anmeldenummer: 15162172.9
(22) Anmeldetag: 01.04.2015
(51) Int. Cl.: H01F 27/34, H01F 27/42, H01F 29/14

(54) **SCHALTUNGSANORDNUNG ZUM VERRINGERN EINES MAGNETISCHEN GLEICHFLUSS-ANTEILS IM KERN EINES TRANSFORMATORS**
CIRCUIT ASSEMBLY FOR REDUCING A MAGNETIC UNIDIRECTIONAL FLUX FRACTION IN THE CORE OF A TRANSFORMER
CIRCUIT DE REDUCTION D'UNE PART DE FLUX CONTINU MAGNETIQUE DANS LE NOYAU D'UN TRANSFORMATEUR

(43) Veröffentlichungstag der Anmeldung: 05.10.2016
(73) Patentinhaber: Siemens Aktiengesellschaft, 80333 München (DE)
(72) Erfinder: Hamberger, Peter, 4202 Kirchschlag bei Linz (AT)
(74) Vertreter: Maier, Daniel Oliver

(56) Entgegenhaltungen:
- US-A1- 2004 196 675
- US-A1- 2013 201 592
- US-B2- 8 896 306

## Beschreibung

### Technisches Gebiet

Die Erfindung betrifft eine Schaltungsanordnung zum Verringern eines magnetischen Gleichfluss-Anteils im Kern eines Transformators, mit einer Messeinrichtung, welche ein dem magnetischen Gleichfluss-Anteil entsprechendes Sensorsignal bereitstellt, mit einer Kompensationswicklung, welche magnetisch mit dem Kern des Transformators gekoppelt ist, mit einer Halbleiter-Schaltvorrichtung, welche elektrisch in einem Strompfad in Reihe mit der Kompensationswicklung angeordnet ist, um in die Kompensationswicklung einen Strom einzuspeisen, dessen Wirkung dem Gleichfluss-Anteil entgegen gerichtet ist, wobei die Halbleiter-Schaltvorrichtung mittels einer von einer Steuereinrichtung bereitgestellten Stellgröße steuerbar ist.

### Stand der Technik

Es ist bekannt, dass es bei elektrischen Transformatoren, wie sie in Energie-Verteilungsnetzen eingesetzt werden, zu einer unerwünschten Einspeisung eines Gleichstroms in die Primärwicklung bzw. in die Sekundärwicklung kommen kann. Eine solche Gleichstromeinspeisung, im Folgenden auch als DC-Anteil bezeichnet, kann beispielsweise von elektronischen Baukomponenten herrühren, wie sie heutzutage bei der Ansteuerung von elektrischen Antrieben oder auch bei der Blindleistungskompensation verwendet werden. Eine andere Ursache können so genannte "Geomagnetically Induced Currents" (GIC) sein.

Ein DC-Anteil hat im Kern des Transformators einen Gleichfluss-Anteil zur Folge, der sich dem Wechselfluss überlagert. Dies führt zu einer unsymmetrischen Aussteuerung des magnetischen Werkstoffs im Kern und bringt eine Reihe von Nachteilen mit sich. Bereits ein Gleichstrom von wenigen Ampere kann eine lokale Erwärmung im Transformator verursachen, was die Lebensdauer der Wicklungsisolation beeinträchtigen kann. Ein weiterer unerwünschter Effekt ist eine erhöhte Geräuschemission bei Betrieb des Transformators. Dies wird insbesondere dann als störend empfunden, wenn der Transformator in der Nähe eines Wohnbereichs installiert ist.

In der PCT/EP2010/064397 wird vorgeschlagen, mittels einer Halbleiter-Schaltvorrichtung, die in einem Stromkreis mit einer Kompensationswicklung in Serie geschalteten ist, unter Nutzung der in der Kompensationswicklung induzierten Spannung, einen pulsierenden Gleichstrom zu erzeugen, der im Mittel den unerwünscht eingespeisten Gleichstromanteil kompensiert. Zur Messung des Gleichfluss-Anteils kann beispielsweise eine Sensoreinrichtung verwendet werden, wie sie in PCT/EP2010/054857 vorgeschlagen ist.

Die Anwendung einer derartigen DC-Kompensation mit einer Halbleiter-Schaltvorrichtung ist auf die maximal zulässige Spannung bzw. Strom der verwendeten leistungselektronischen Bauelemente begrenzt sind. Je nach Ausbildung der Kompensationswicklung ergibt sich folgendes Problem: Wird die Windungszahl der Kompensationswicklung niedrig gehalten, dann muss die Halbleiter-Schaltvorrichtung einen großen Kompensations-Strom erzeugen, was mit einer entsprechend großen Wärmeentwicklung der Bauelemente einhergeht. Wird andererseits eine Kompensationswicklung mit einer hohen Windungszahl eingesetzt, erreicht die in der Kompensationswicklung induzierte Spannung schnell die maximal zulässige Spannungsgrenze der verwendeten Halbleiterschalter.

In der praktischen Anwendung einer DC-Kompensation mit Halbleitern bedeutet dies, dass mittels der zum heutigen Zeitpunkt verfügbaren Bauelemente der Einsatz auf eine induzierte Spannung in der Kompensationswicklung von etwa unter 700 V eingeschränkt ist (Niederspannungsrichtlinie).

Das Problem der DC-Kompensation existiert aber auch bei großen Transformatoren, insbesondere bei so genannten HGÜ-Transformatoren, bei denen die in der Kompensationswicklung induzierte Spannung weit über 700 V liegen kann.

### Darstellung der Erfindung

Es ist eine Aufgabe der vorliegenden Erfindung, eine Schaltungsanordnung zur Verringerung eines Gleichanteils eines magnetischen Flusses in einem Transformator anzugeben, welche im praktischen Einsatz auch für Transformatoren in einem sehr großen Leistungsbereich anwendbar ist.

Diese Aufgabe wird durch Schaltungsanordnung mit den Merkmalen des Patentanspruchs 1 gelöst. Vorteilhafte Ausgestaltungen, Aspekte und Einzelheiten der Erfindung ergeben sich aus den abhängigen Ansprüchen, der Beschreibung und der beigefügten Zeichnungen.

Die Erfindung geht von dem Gedanken aus, die in der Kompensationswicklung induzierte elektrische Spannung mittels eines induktiven Spannungsteilers so herabzusetzen, dass für die Halbleiter-Schalteinrichtung heutzutage verfügbare Halbleiter-Bauelemente verwendet werden können, ohne dass deren maximal zulässige Spannung überschritten wird. Damit eröffnet sich der Anwendungsbereich der DC-Kompensation mit einer Halbleiter-Schaltvorrichtung auch für Leistungstransformatoren sehr großer Leistung. Insbesondere ist eine DC-Kompensation nun auch für HGÜ-Transformatoren möglich. Der gemäß der Erfindung verwendete induktive Spannungsteiler besteht aus einer Reihenschaltung komplexer Widerstände. Eine erste Impedanz ist in einem Stromkreis in Reihe mit der Kompensationswicklung und der Halbleiter-Schaltvorrichtung angeordnet, wobei ein Parallelschwingkreis dieser ersten Impedanz parallel geschaltet ist. Eine zweite Impedanz ist parallel zur Halbleiter-Schaltvorrichtung angeordnet. Die beiden Impedanzen sind gemäß der Spannungsteilerregel so ausgelegt, dass an der Halbleiter-Schaltvorrichtung die Spannung herabgesetzt ist, so dass derzeit verfügbare Halbleiterschaltelemente zum Einsatz kommen können. Die Ansteuerung der Halbleiter-Schalteinrichtung kann wie in der eingangs erwähnten PCT/EP2010/064397 ausgeführt sein. Wie dort offenbart, wird die induzierte Spannung zur Erzeugung eines Kompensationsstroms genutzt, welcher bidirektional in die Kompensationswicklung eingespeist werden kann. Das Einschalten einzelner Bauelemente der Halbleiter-Schaltvorrichtung erfolgt netzsynchron und nach einer vorgegebenen Schaltstrategie. Der Einschaltzeitpunkt wird von der Phase der in der Kompensationswicklung induzierten Spannung getriggert, und die Einschaltdauer richtet sich nach Maßgabe eines Sensorsignals, welche eine Messeinrichtung bereitstellt. Auf diese Weise wird ein sinusförmig pulsierender Gleichstrom in die Kompensationswicklung eingespeist, dessen Größe durch eine Strombegrenzungseinrichtung begrenzt wird. Eine externe Energiequelle, das heißt eine Batterie oder ein Kondensator, ist für die Erzeugung dieses pulsierenden Gleichstroms nicht erforderlich. Die Stromflussdauer dieses pulsierenden Gleichstroms kann auf einfache Weise und sehr genau nach Maßgabe des zugeführten Sensorsignals, welches Richtung und Größe des zu kompensierenden DC-Anteils vorgibt, eingestellt werden. Der Mittelwert dieses so erzeugten gepulsten Gleichstroms bewirkt im weichmagnetischen Kern des Transformators eine Reduktion des Gleichfluss-Anteils, beziehungsweise hebt dessen Wirkung in Kern vollständig auf. Dadurch kommt es nicht mehr zu der eingangs erwähnten unerwünschten unsymmetrischen Aussteuerung des weichmagnetischen Kerns. In Folge davon ist die thermische Belastung der Wicklung des Transformators geringer. Bei Betrieb des Transformators sind Verluste und Geräusche geringer. Die Vorrichtung lässt sich dabei mit vergleichsweise einfachen Mitteln realisieren. Dabei können sowohl diskrete und / oder programmierbare Bausteine verwendet werden, welche kommerziell verfügbar sind. Von großem Vorteil ist dabei, dass für die Erzeugung des Kompensationsstroms I_{GL} kein Energiespeicher, wie beispielsweise eine Batterie oder ein Kondensator, erforderlich ist. Mit anderen Worten, die Energie zur Erzeugung des Kompensationsstroms I_{GL} wird direkt der Kompensationswicklung entnommen. Auf Grund ihrer Einfachheit ist die Zuverlässigkeit der Schaltungsanordnung hoch. Sie ist für den wartungsarmen Langzeitbetrieb eines Transformators in einem Energieverteilungsnetz gut geeignet. Der Einsatzbereich umfasst sowohl Transformatoren im Nieder- oder Mittelspannungsbereich, wie auch Transformatoren sehr hohe Leistung (HGÜ-Transformatoren). Weder die Baugröße noch sicherheitsrelevante Einrichtungen oder andere Auslegungskriterien des Transformators werden durch den Einsatz der Erfindung ungünstig beeinflusst.

Zum Zweck der Strombegrenzung ist im Strompfad in Reihe mit der Halbleiter-Schaltvorrichtung und der Kompensationswicklung eine Induktivität angeordnet. Der Vorteil der Verwendung einer Induktivität im Strompfad liegt alleine schon in der Tatsache begründet, dass der Spulenstrom der Kompensationswicklung dem zeitlichen Integral der Spulenspannung entspricht und somit durch eine geeignete Steuerstrategie über eine Periode in einfacher Weise Gleichanteile dieses Spannungsintegrals und somit des Spulenstroms erzielbar sind. Bei entsprechender Wahl der Induktivität kann die Belastung beim Einschalten sehr gering gehalten werden, da die zeitliche Änderung des Stroms im Einschaltaugenblick durch die Induktivität begrenzt ist. Grundsätzlich könnte anstelle der Induktivität auch ein anderer Zweipol verwendet werden. Schaltungstechnisch wäre auch ein ohmscher Widerstand denkbar, dessen Wirkverluste wären aber von Nachteil.

In einer bevorzugten Ausführungsform weist der Parallelschwingkreis eine Resonanzfrequenz auf, die auf die Netzfrequenz des Transformators abgestimmt ist. Damit wirkt er für Wechselstrom sperrend, nicht aber für den transiente Gleichstrom, d.h. Kompensationsstrom. Der Parallelschwingkreis hat für Netzfrequenz eine sehr hohe Impedanz (im theoretischen Idealfall eine unendlich hohe Impedanz). Für Ströme mit anderen Frequenzen sinkt die Impedanz je nach Güte rasch ab.

Bevorzugt ist, dass in Reihe zur ersten Impedanz eine Sperrimpedanz und in Reihe zur zweiten Impedanz eine Sperrimpedanz geschalteten ist. Die Induktivität bewirkt, dass man die Induktivität zum Parallelzweig individuell einstellen kann.

In einer bevorzugten Ausführung kann vorgesehen sein, dass die Halbleiter-Schaltvorrichtung durch ein von einer Steuereinheit bereitgestelltes Steuersignal so gesteuert ist, dass der im Strompfad fließende Strom (I_{GL}) ein pulsierende Gleichstrom ist und die Halbleiter-Schaltvorrichtung selbsttätig ausschaltet, wenn der Strom (I_{GL}) im Strompfad null oder nahezu Null ist. Der Thyristor geht bei Stromnulldurchgang in den sperrenden Zustand über. Dadurch ergibt sich ein Gleichstrom mit überlagerten Oberwellen.

In einer bevorzugten Ausführung kann auch vorgesehen sein, dass die Halbleiter-Schaltvorrichtung aus zwei antiparallel geschalteten Thyristoren, GTO oder IGBT gebildet ist. Der Vorteil der Verwendung eines Thyristors liegt zunächst darin, dass ein Thyristor mit einem Stromimpuls "gezündet", das heißt in den leitenden Zustand gebracht werden kann. Während der positiven Halbschwingung der Netzspannung hat der Thyristor bis zum nächsten Stromnulldurchgang die Eigenschaft einer Diode. Das Ende der Stromflussdauer wird vom Thyristor selbst bewirkt, indem der Haltestrom unterschritten wird und der Thyristor automatisch " löscht", das heißt in den nicht leitenden Zustand übergeht. Selbstverständlich sind auch andere Halbleiterschalter, wie GTO, IGBT Transistoren oder andere Schaltelemente denkbar.

Es kann günstig sein, wenn die Halbleiter-Halbleiter-Schaltvorrichtung und die Steuereinrichtung außerhalb des Kessels eines Transformators angeordnet werden. Die gesamte elektronische Schaltung ist dadurch von außen für Kontrolle und Wartung zugänglich.

### Kurzbeschreibung der Zeichnung

Zur weiteren Erläuterung der Erfindung wird im nachfolgenden Teil der Beschreibung auf die Zeichnungen Bezug genommen, aus denen weitere vorteilhafte Ausgestaltungen, Einzelheiten und Weiterbildungen der Erfindung anhand eines nicht einschränkenden Ausführungsbeispiels zu entnehmen sind.

Es zeigen:

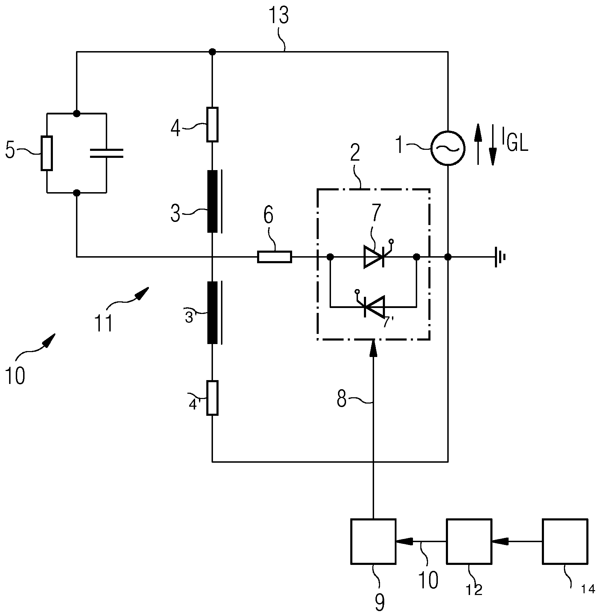

- Figur 1: ein Ausführungsbeispiel der erfindungsgemäßen Schaltvorrichtung.

### Ausführung der Erfindung

Die Figur 1 zeigt eine Schaltvorrichtung 10 gemäß einem Ausführungsbeispiel der Erfindung in einer vereinfachten Darstellung. Die Schaltvorrichtung 10 besteht im Wesentlichen aus einem induktiven Spannungsteiler 11, der aus einem ersten komplexen Widerstand, der Impedanz 3, und einem zweiten komplexen Widerstand, der Impedanz 3', besteht. Der erste Widerstand 3 ist dabei in einem Strompfad 13 in Serie mit der Halbleiter-Schalteinrichtung 2 und der Kompensationswicklung 1 geschalteten. In Figur 1 ist die Kompensationswicklung 1 mit dem Symbol einer Spannungsquelle gezeichnet. Die in der Kompensationswicklung 1 induzierte Spannung bildet die Gesamtspannung des Spannungsteilers 3, 3'. Die Impedanzen 3, 3' sind auf eine magnetischen Kern angeordnet und hinsichtlich ihrer Windungszahl unterschiedlich. Durch geeignete Ausführung der Widerstände 3, 3', beispielsweise durch geeignete Wahl der Windungszahlen, lassen sich die Teilspannungen an den induktiven Widerstanden 3 bzw. 3' entsprechend gestalten (Spannungsteilerregel). Gemäß der Erfindung wird die Teilspannung am Widerstand 3' so gewählt, dass die maximal zulässige Spannung für die in der Halbleiter-Schaltvorrichtung 2 verwendeten Bauelemente 7, bzw. 7' herabgesetzt ist, so dass ein zulässiger maximaler Spannungswert nicht überschritten wird. Über die beiden Impedanzen 3, 3' fließt nur ein sehr geringer Erreger Strom. Damit kein nennenswerter Strom über die beiden Impedanzen 3 bzw. 3' fließt (dies würde einen Verlust bei der Erzeugung des Kompensationsstroms gleichkommen), ist zu jeder Impedanz 3 bzw. 3' jeweils eine Sperrimpedanz 4 bzw. 4' geschalteten. Diese Sperrimpedanz 4 bzw. 4' sind größer als die Impedanz der Induktivität des Parallelschwingkreis 5.

Die Sperrimpedanz 4 bzw. 4' kann eine Magnetspule oder Luftspule sein.

Wie aus dem Schaltplan der Figur 1 hervorgeht, ist ein Parallelschwingkreis 5 der oberen Impedanz 3 parallel geschaltet. Der Parallelschwingkreis besteht aus einer Induktivität und einem parallelgeschalteten Kondensator. Diese beiden Bauelemente sind hinsichtlich ihrer Resonanzfrequenz so bemessen, dass der Parallelschwingkreis 5 für die Netzfrequenz des Transformators einen Sperrkreis bildet, d.h. sein Widerstand für Wechselstrom sehr groß ist (Impedanz ist sperren). Für Gleichstrom ist sein Widerstand hingegen gering. Wird nun einer der beiden Thyristoren 7 bzw. 7' der Halbleiter-Schaltvorrichtung 2 durchgeschalteten, so kommt es zur Ausbildung eines Kompensationsstroms I_{GL} (Gleichstrom) dessen Strompfad über die Drossel des Parallelschwingkreises 5 führt. Wird beispielsweise der in Figur 1 im Funktionsblock 2 oben dargestellte Thyristor 7 gezündet, so kommt es zur Ausbildung eines Kompensationsstroms I_{GL} der im Strompfad 13 entgegen dem Uhrzeigersinn fließt und in Figur 1 von unten nach oben in die Kompensationswicklung 1 eingespeist wird. Die Richtung des Kompensationsstroms I_{GL} kehrt sich um, wenn der untere Thyristor 7' im Funktionsblock 2 gezündet wird, so dass der Kompensationsstroms I_{GL} im Uhrzeigersinn über die Induktivität des Parallelschwingkreis 5 in die Kompensationswicklung 1 eingespeist wird; (in der Darstellung der Figur 1 in diesem Fall Pfeil von oben nach unten).

Durch die erfindungsgemäße Schaltungsanordnung ist ein bidirektionaler Stromfluss I_{GL} in der Kompensationswicklung 1 möglich, so dass der störende Gleichfluss-Anteil in Kern 14 des Transformators kompensiert werden kann. Im Ergebnis führt diese Kompensation dazu, dass es nicht mehr zur unsymmetrischen Aussteuerung des Magnetmaterials mit den eingangs dargestellten negativen Auswirkungen hinsichtlich Geräuschentwicklung und lokaler Erwärmung kommt.

Wie in Figur 1 dargestellt, ist im Strompfad 13 zum Zweck der Strombegrenzung eine Strombegrenzungsdrossel 6 geschaltet. Die Ansteuerung der Halbleiter-Schalteinrichtung 2 erfolgt durch Steuersignal 8, welches eine Steuereinrichtung 9 bereitstellt. Die Steuereinrichtung 9 empfängt eingangsseitig das Signal einer Magnetfeld-Messeinrichtung 12, welche den magnetischen Gleichfluss-Anteil im Kern 14 eines Transformators erfasst. Das Steuersignal 8 berücksichtigt dabei Größe und Richtung des detektierten Gleichfluss-Anteils.

Wie in der eingangs erwähnten PCT/EP2010/064397 erläutert, weist der Kompensationsstrom I_{GL} die Form aneinander gereihter sinusförmiger Halbwellen auf, die von Stromlücken unterbrochen sind, wobei jede Halbwelle symmetrisch zur halben Periodendauer der induzierten Spannung ist. Zusammenfassend lässt sich sagen, dass durch die Erfindung auch eine Gleichstromkompensation für sehr große LeistungsTransformatoren möglich ist. Beispielsweise kann der in PCT/EP2010/064397 offenbarte Lösungsansatz mit derzeit verfügbaren Halbleiterbauelementen auch dann eingesetzt werden, wenn die in der Kompensationswicklung induzierte Spannung weit über 700 V liegt.

### Zusammenstellung der verwendeten AI korrigiere Bezugszeichen

- 1: Kompensationswicklung
- 2: Halbleiter-Schaltvorrichtung
- 3, 3': Impedanz, komplexer Widerstand
- 4, 4': Sperrimpedanz
- 5: Parallelzweig
- 6: Strombegrenzungsdrossel
- 7, 7': Thyristor
- 8: Steuersignal
- 9: Steuereinheit
- 10: Messsignal
- 11: induktiver Spannungsteiler
- 12: Magnetfeld-Messeinrichtung
- 13: Strompfad 14 Kern

- I_{GL}: Kompensationsstrom

## Patentansprüche

1. Schaltungsanordnung zur Verringerung eines magnetischen Gleichfluss-Anteils im Kern (14) eines Transformators, umfassend:
- eine Messeinrichtung (12), welche ein dem magnetischen Gleichfluss-Anteil entsprechendes Sensorsignal (10) bereitstellt,
- eine Kompensationswicklung (1), welche magnetisch mit dem Kern (14) des Transformators gekoppelt ist,
- eine Halbleiter-Schaltvorrichtung (2), welche elektrisch in einem Strompfad (13) in Reihe mit der Kompensationswicklung (1) angeordnet ist, um in die Kompensationswicklung (1) einen Strom (I_{GL}) einzuspeisen, dessen Wirkung dem Gleichfluss-Anteil entgegen gerichtet ist, wobei die Halbleiter-Schaltvorrichtung (2) mittels einer von einer Steuereinrichtung (9) bereitgestellten Steuersignals (8) steuerbar ist,
- **gekennzeichnet durch,**
einen induktiven Spannungsteiler (11), aufweisend:
eine erste Impedanz (3), die im Stromkreis (13) in Reihe mit Kompensationswicklung (1) und Halbleiter-Schaltvorrichtung (2) angeordnet ist, wobei dieser ersten Impedanz (3) ein Parallelschwingkreis (5) parallel geschaltet ist,
eine zweite Impedanz (3'), die parallel zur Halbleiter-Schaltvorrichtung (2) angeordnet ist.

2. Schaltungsanordnung nach Anspruch 1, **dadurch gekennzeichnet, dass** der Parallelschwingkreis (5) eine Resonanzfrequenz aufweist, die auf die Netzfrequenz des Transformators abgestimmt ist.

3. Schaltungsanordnung nach Anspruch 1 oder Anspruch 2, **dadurch gekennzeichnet, dass** in Reihe zur ersten Impedanz (3) eine Sperrimpedanz (4) und in Reihe zur zweiten Impedanz (3') eine Sperrimpedanz (4') geschalteten ist.

4. Vorrichtung nach einem der Ansprüche 1 bis 4, **dadurch gekennzeichnet, dass** die Halbleiter-Schaltvorrichtung (2) durch ein von einer Steuereinheit (9) bereitgestelltes Steuersignal (8) so gesteuert ist, dass der im Strompfad (13) fließende Strom (I_{GL}) ein pulsierender Gleichstrom ist und die Halbleiter-Schaltvorrichtung (2) selbsttätig ausschaltet, wenn der Strom (I_{GL}) im Strompfad (13) null oder nahezu Null ist.

5. Vorrichtung nach Anspruch 4, **dadurch gekennzeichnet, dass** der pulsierende Gleichstrom (I_{GL}) aus periodisch wiederkehrenden Halbwellen und aus benachbarte Halbwellen verbindende Stromlücken gebildet ist.

6. Vorrichtung nach Anspruch 5, **dadurch gekennzeichnet, dass** die Halbleiter-Schaltvorrichtung (2) aus zwei antiparallel geschalteten Thyristoren, GTO oder IGBT gebildet ist.

7. Vorrichtung nach Anspruch 6, **dadurch gekennzeichnet, dass** die Halbleiter-Schaltvorrichtung (2) außerhalb eines Transformatorkessels angeordnet ist.

## Claims

1. Circuit assembly for reducing a DC magnetic flux component in the core (14) of a transformer, comprising:
- a measuring device (12) which provides a sensor signal (10) corresponding to the magnetic unidirectional flux fraction,
- a compensation winding (1) which is magnetically coupled to the core (14) of the transformer,
- a semiconductor switching device (2) which is electrically arranged in a current path (13) in series with the compensation winding (1), in order to feed a current (I_{GL}) into the compensation winding (1), the action of which is directed opposite to the unidirectional flux fraction, wherein the semiconductor switching device (2) can be controlled by means of a control signal (8) provided by a control device (9),
- **characterised by**
an inductive voltage divider (11), having:
a first impedance (3) which is arranged in the circuit (13) in series with the compensation winding (1) and the semiconductor switching device (2), wherein a parallel resonant circuit (5) is connected in parallel to said first impedance (3),
a second impedance (3') which is arranged parallel to the semiconductor switching device (2).

2. Circuit assembly according to claim 1, **characterised in that** the parallel resonant circuit (5) has a resonance frequency which is tuned to the mains frequency of the transformer.

3. Circuit assembly according to claim 1 or claim 2, **characterised in that** a blocking impedance (4) is connected in series to the first impedance (3) and a blocking impedance (4') is connected in series to the second impedance (3').

4. Device according to one of claims 1 to 4, **characterised in that** the semiconductor switching device (2) is controlled by a control signal (8) provided by a control unit (9), such that the current (I_{GL}) flowing in the current path (13) is a pulsating direct current and automatically switches off the semiconductor switching device (2) when the current (I_{GL}) in the current path (13) is zero or almost zero.

5. Device according to claim 4, **characterised in that** the pulsating direct current (I_{GL}) is formed from periodically recurring half-waves and from current gaps connecting adjacent half-waves.

6. Device according to claim 5, **characterised in that** the semiconductor switching device (2) is formed from two antiparallel-connected thyristors, GTO or IGBT.

7. Device according to claim 6, **characterised in that** the semiconductor switching device (2) is arranged outside a transformer tank.

## Revendications

1. Circuit de réduction d'une part de flux continu magnétique dans le noyau (14) d'un transformateur, comprenant :
- un dispositif de mesure (12) qui fournit un signal de capteur (10) correspondant à la part de flux continu magnétique ;
- un enroulement de compensation (1) qui est couplé magnétiquement au noyau (14) du transformateur ;
- un contacteur à semi-conducteur (2) qui est agencé électriquement dans un trajet de courant (13) en série avec l'enroulement de compensation (1) pour injecter dans l'enroulement de compensation (1) un courant (IGL) dont l'effet est contraire à la part de flux continu, le contacteur à semi-conducteur (2) pouvant être commandé au moyen d'un signal de commande (8) fourni par un dispositif de commande (9),
**caractérisé par**
un diviseur de tension inductif (11), comportant :
une première impédance (3) qui est agencée dans le circuit électrique (13) en série avec l'enroulement de compensation (1) et le contacteur à semi-conducteur (2),
un circuit oscillant parallèle (5) étant monté en parallèle avec cette première impédance (3) ;
une deuxième impédance (3') montée en parallèle avec le contacteur à semi-conducteur (2).

2. Circuit selon la revendication 1, **caractérisé en ce que** le circuit oscillant parallèle (5) présente une fréquence de résonance qui est accordée sur la fréquence de réseau du transformateur.

3. Circuit selon la revendication 1 ou la revendication 2, **caractérisé en ce qu'**une impédance d'isolement (4) est montée en série avec la première impédance (3) et une impédance d'isolement (4') est montée en série avec la deuxième impédance (3').

4. Dispositif selon l'une des revendications 1 à 4, **caractérisé en ce que** le contacteur à semi-conducteur (2) est commandé par un signal de commande (8) fourni par une unité de commande (9) de manière telle que le courant (IGL) passant par le trajet de courant (13) est un courant continu pulsatoire et que le contacteur à semi-conducteur (2) se coupe automatiquement lorsque le courant (IGL) dans le trajet de courant (13) est nul ou presque nul.

5. Dispositif selon la revendication 4, **caractérisé en ce que** le courant continu pulsatoire (IGL) est formé par des demi-ondes progressives périodiques et des lacunes électriques reliant des demi-ondes voisines.

6. Dispositif selon la revendication 5, **caractérisé en ce que** le contacteur à semi-conducteur (2) est formé par deux thyristors antiparallèles, GTO ou IGBT.

7. Dispositif selon la revendication 6, **caractérisé en ce que** le contacteur à semi-conducteur (2) est agencé en dehors d'une cuve de transformateur.
